# EUROPEAN PATENT APPLICATION

(11) **EP 1 435 618 A2**
(43) Date of publication of application: **07.07.2004**
(21) Application number: 03009974.1
(22) Date of filing: 30.04.2003
(51) Int. Cl.: G11B 27/034, G11B 20/12, H04N 9/804, H04N 5/85, G11C 7/16, G11B 7/00

(54) **Video editing device and video editing method**

(30) Priority: 06.01.2003 CN 03100030; 27.02.2003 CN 03106713
(71) Applicant: ACER INCORPORATED, Taipei Hsien 221 (TW)
(72) Inventor: Chih-Yi, Chen, Hsichih, Taipei Hsien 221 (TW); Bei-Chuan, Chen, Hsichih, Taipei Hsien 221 (TW); Chao-Cheng, Li, Hsichih, Taipei Hsien 221 (TW); Mong-Ling, Chiao, Hsichih, Taipei Hsien 221 (TW); Nai-Jun, Wang, Hsichih, Taipei Hsien 221 (TW)
(74) Representative: Weber, Joachim, Dr.

(57) **Abstract**

A portable video-editing device includes a reader module, a recording module, and a control module. The reader module is used to read data contained in a first storage medium of a first file system, and the recording module is used to record data into a second storage medium of the second file system. The control module includes a transcribing unit for transcribing data between the first file system and the second file system, and a MPEG encoder for encoding MPEG streams. Image files contained in a memory card inserted into the reader are MPEG-encoded, transcribed, and backup in a video disc ready for playback. A plurality of sections of video data can be edited and backup into a single disc.

## Description

### FIELD OF THE INVENTION

The present invention is related to a video editing device, and more particularly to a video editing device with user-friendly operability and possessing a high mobility and a surpassing capability of transcribing data among different file systems and recording the transcribed data in a storage medium.

### BACKGROUND OF THE INVENTION

Now there are various kinds of video editing software in the market, most of them only provide users the functions of burning, transmission, compression, input and output or create/edit etc. such users always buy many video compact disks, but only want to collect some part of the film. And it seems to be a great work to finish it through some video editing software. According to the foregoing description, this invention discloses a video editing system, by that, users can capture any section of the video file and collect the captured sections to produce complete video information they anticipated and present it in a compact disk.

In addition, when user desires to use a portable electronic device, such as a digital still camera in an outdoor environment, if there is no free space available in the memory card serving as the storage medium of the portable electronic device, the image data contained within the portable electronic device can not be transcribed and recorded in other storage media due to lack of a computer equipment. The portable electronic device cannot be used any longer and thereby causes considerable inconvenience. Also, in a situation where the user needs to have the image data transformed into a slide show or a simple movie for immediate playback on a video disc player, he may have to have a computer nearby and perform necessary editing using typical authoring software, which requires manual labor and sometimes leads to a waste of time.

### SUMMARY OF THE INVENTION

It is therefore one object of the invention to provide users a video editing system, by that, users can capture any section of the video file and collect the captured video sections to produce a complete video information and burn in a compact disk. One object of the invention is to provide users a video editing method; any kind of video edit capture system can easily reach their needs by that. One object of the invention is to provide users a video editing system, by that, users can capture a batch of sections of the video file and collect the captured sections to produce video information and burn in a compact disk.

It is also an object of the present invention to provide a standalone and portable transcription device for video editing use.

The portable transcription device according to the present invention is capable of transcribing the data contained in a first storage medium so as to be recorded in a second storage medium, and the file system used in the first storage medium is different in nature from the file system used in the second storage medium.

One further object of the present invention is that a plurality of image files contained in the first storage medium are automatically edited and recorded into the second storage medium in a file format ready for playback in typical video disc players according to a single action of the user.

The foregoing advantages and objects of the present invention is accomplished by the features of claim 1, and can be best understood by the following preferred embodiment and accompanying drawings, in which:

### BRIEF DESCRIPTION OF THE DRAWINGS

Figure 1 illustrates one system structure of a video editing system of the present invention;

Figure 2 illustrates the operation action of the capture device 101;

Figure 3 illustrates the operation action of the format-making device 102;

Figure 4 illustrates the operation action of the burning device 103-1;

Figure 5 illustrates the operation action of the burning device 103-2;

Figure 6 illustrates the flow chart about the video editing method of this invention;

Figure 7 illustrates a second system structure of a video editing system of the present invention;

Figure 8 illustrates how the main program 700 and the capture function program 701 work in coordination;

Figure 9 illustrates how the capture function program 701 and the format-making function program 701 work in coordination;

Figure 10 illustrates the action of the burning function program;

Figure 11 illustrates the real operation action of the video editing system;

Fig. 12 is a three-dimensional exploded view showing a portable transcription device according to one embodiment of the present invention;

Fig. 13 is a plan view illustrating the relationships among the file system, operating system, and storage medium;

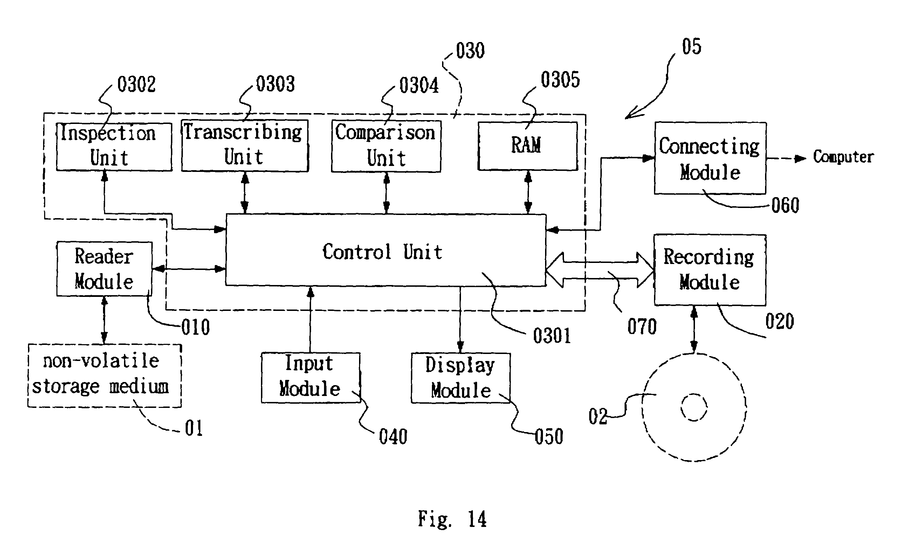

Fig. 14 is a systematic block diagram showing a circuit configuration of a portable transcription device according to a preferred embodiment of the present invention;

Fig. 15 is a flowchart diagram illustrating the procedural steps of data transcription between different file systems accomplished by a transcribing unit incorporated in the portable transcription device according to the present invention; and

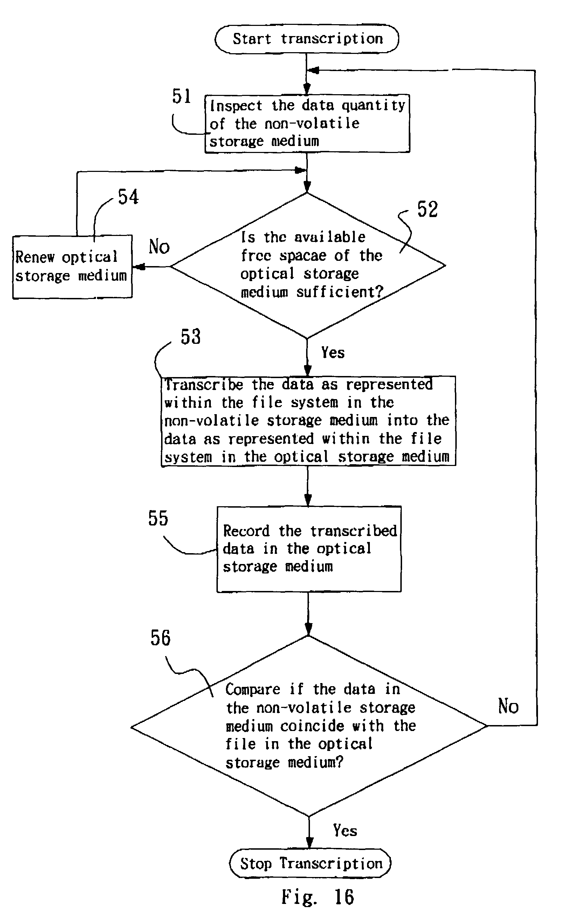

Fig. 16 is a flowchart diagram illustrating the procedural steps of data transcription process using a portable transcription device according to the present invention.

Fig. 17 is a block diagram illustrating the portable transcription device for video editing use according to one embodiment of the present invention.

Fig. 18 and Fig. 19 are flowchart diagrams illustrating the procedural steps of using the portable transcription device of Fig. 17 to record video discs.

### DETAILED DESCRIPTION OF THE PREFERRED EMBODIMENTS

The examples and illustrations embodying the present invention will be manifested by the descriptions of the following preferred embodiment in reference to the drawings attached therewith.

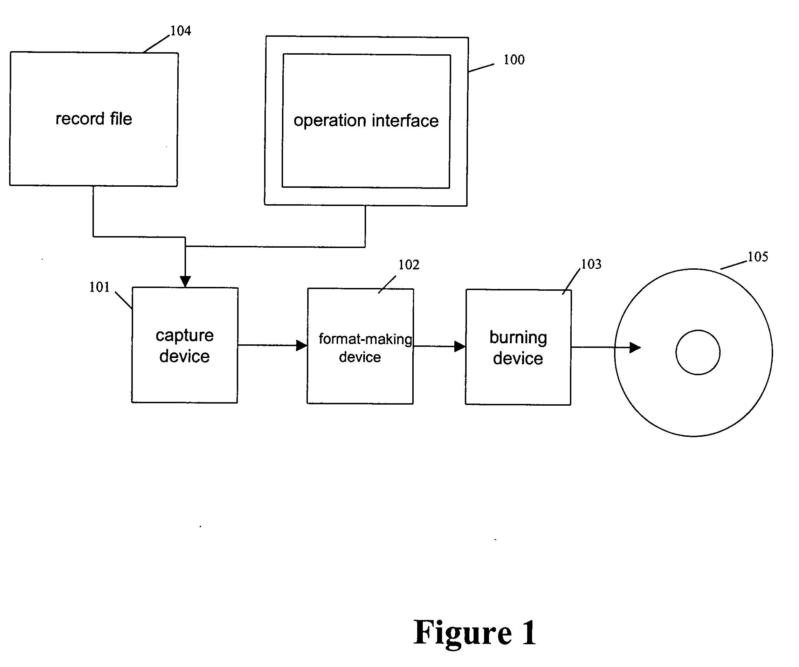

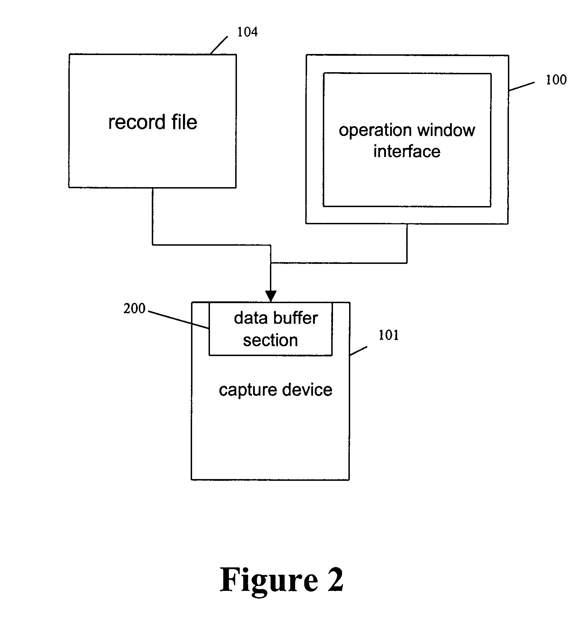

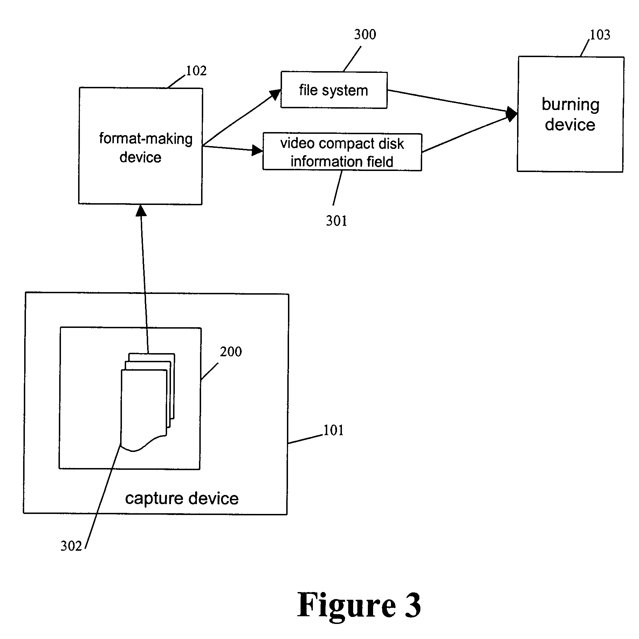

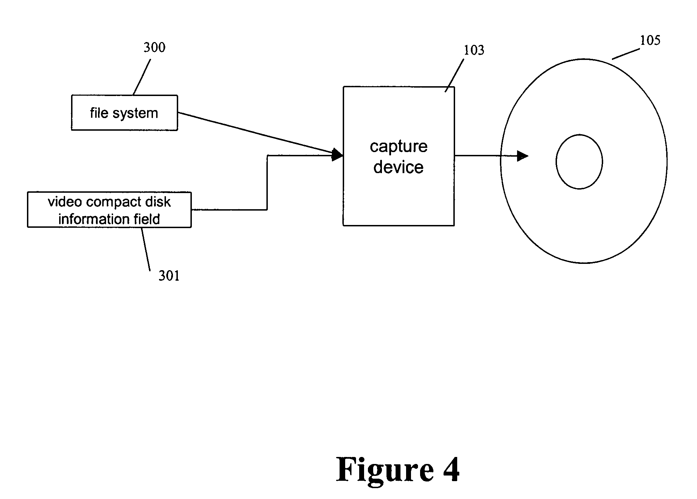

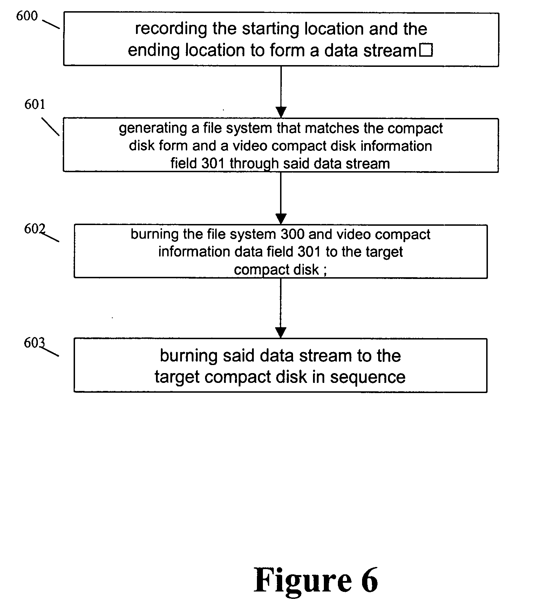

Figure 1 illustrates a system structure of the inventive editing system that comprises an operation interface 100, a record file 104, a capture device 101, a format-making device 102, a burning device 103 and a targeted compact disk 105. We can get the idea from this figure, the connection about the said components are: the operation interface 100 and the record file 104 connect the capture device 101, the capture device 101 connect the format-making device 102, the format-making device 102 connect the burning device 103 and the burning device 103 connect the control component of the targeted compact disk 105(that is not shown in the figure). Figure 2 illustrates the operation action of the capture device 101. In this figure, the capture device 101 records the starting location and the ending location of the plurality sections through the operation interface 100 or the record file 104 and records them in the data buffer section 200 of the capture device 101. Coming after the figure 3, it illustrates the operation action of the format-making device 102. The format-making device produces a file system 300 that matches the compact disk form and a video compact disk information field 301 through the plurality sections 302 recorded in the data buffer section 200 of the capture device 101,and then transmits them to the burning device 103. Figure 4 illustrates the operation action one of the burning device 103; the burning device 103previously burns the file system 300 and the video compact disk information field 301 to the objective disk 105.

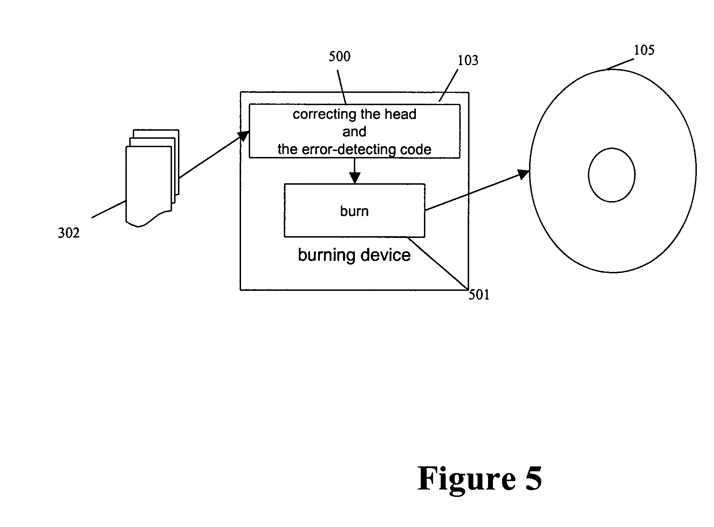

Figure 5 illustrates the operation action two of the burning device 103,the burning device 103 comprises at least two functions, one function is correcting the head and the error-detecting code 500,and the other function is burning 501. The burning device 103 reads the plurality sections 302 through the capture device 101 and the format-making device in sequence, and then corrects each section head and the error-detecting code of the targeted compact disk 105 through the function 500 of correcting head and error-detecting to burn the plurality sections 302 to the targeted compact disk 105 in sequence.

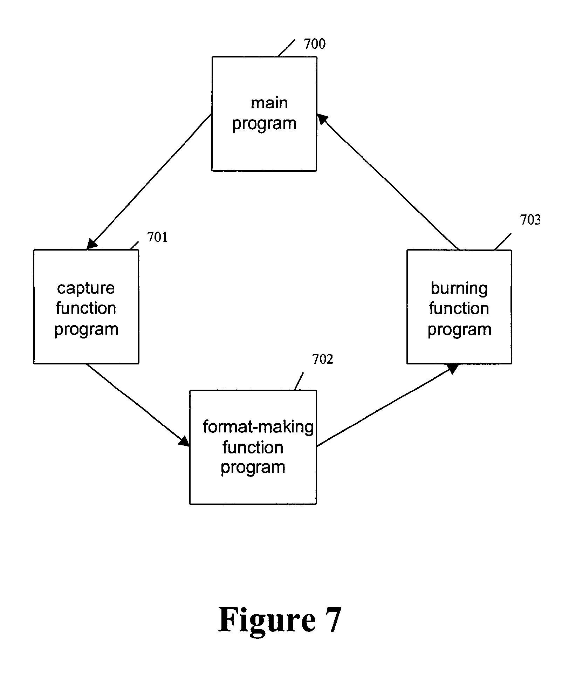

Besides, the video editing method of the invention is comprised of the following steps shown as the figure 6; step 600: recording the starting location and the ending location 200 to form a data stream. Step 601: generating a file system 300 that matches the compact disk form and a video compact disk information field 301 through the said data stream. Step 602: burning the file system 300 and video compact information data field 301 to the targeted compact disk 105, and then correcting each section head and the error-detecting code of the targeted compact disk 105 to load the said data stream in sequence. Finally, step 603, burning the said data stream to the targeted compact disk 105 in sequence.

The video editing system can either apply to software-design, the video edit software comprises a main program 700, a capture function program 701, a format-making function program 702 and a burning function program 703. As shown in the figure 7, the calling way in the example is at least comprised of the main program 700 calls the capture function program 701,the capture function program 701 calls the format-making function program 702 and the forming-making function program 702 calls the burning function program 703. Besides that, return the main program 700 after the burning function program 703 finished the program.

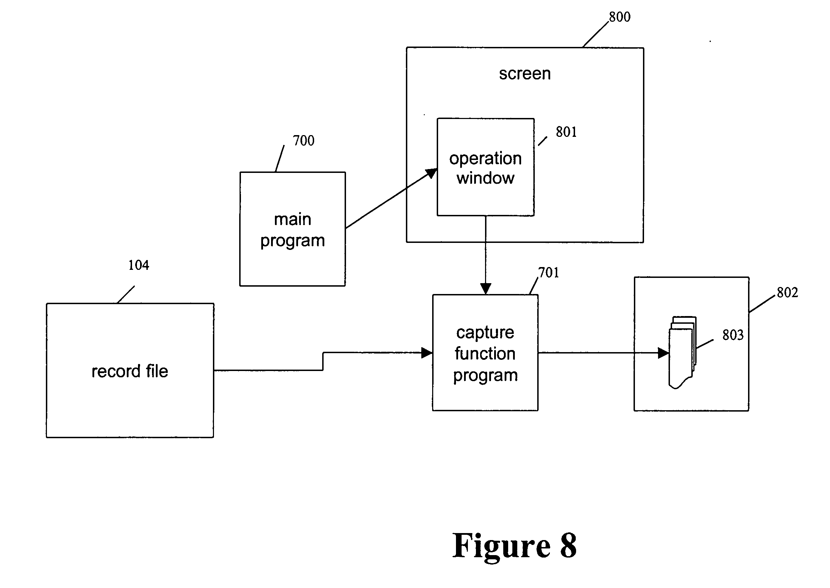

Figure 8 illustrates how the main program 700 and the capture function program 701 work in coordination. In this figure, the main program 700 generates an operation window in the screen 800. It can let users play a plurality of video compact disk in the operation window as soon as possible to record the starting location and the ending location of the plurality disks through calling the capture function program 701. The capture function program records the plurality sections or directly uses the starting location and the ending location of the plurality sections previously set by the record file 104, and then generates a sequence of data stream 803 thereof to temporarily store it in the data buffer section 802.

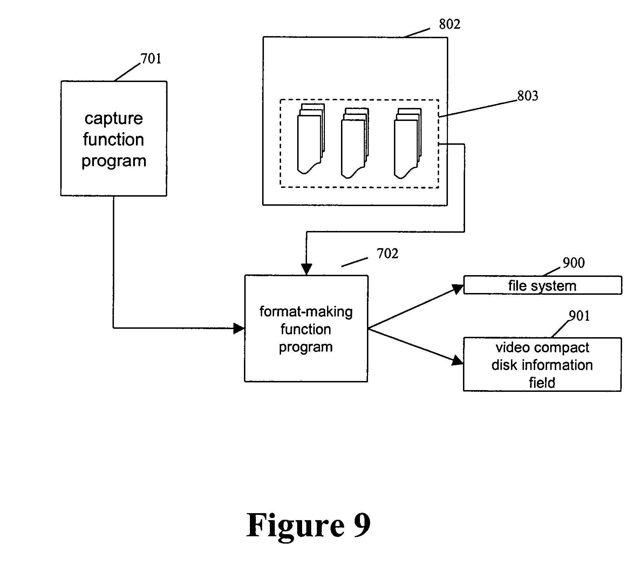

Coming after the figure 9, it illustrates how the capture function program 701 and the format-making function program 701 work in coordination. After the capture function program 701 finished the action in the figure 8, it calls the format-making function 702. The format-making function program 702 produces a file system 900 that matches the compact disk form and a video compact disk information field 901 through the data stream 803.

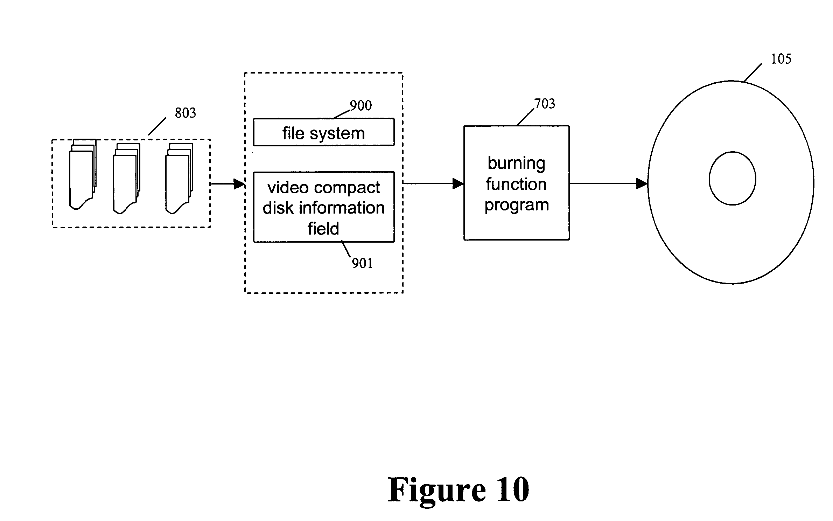

Coming after the figure 10, it illustrates the action of the burning function program. While the format-making function program 702 finishes the action in the figure 9,the data buffer section 802 has temporarily stored the data stream 803, the file system 900 and the video compact disk information field 901. The format-making function program calls the burning function program 703. The burning function program 703 checks whether the cd-rw stored a targeted compact disk 105 or not, and then records the file system 9.00 and video compact information data field 901 to the targeted compact disk 105. And corrects each section head and the error-detecting code of the disk to load the said data stream in sequence then burn the said data stream 803 to the targeted compact disk 105 in sequence. Finally, it becomes the video compact disk that users edit.

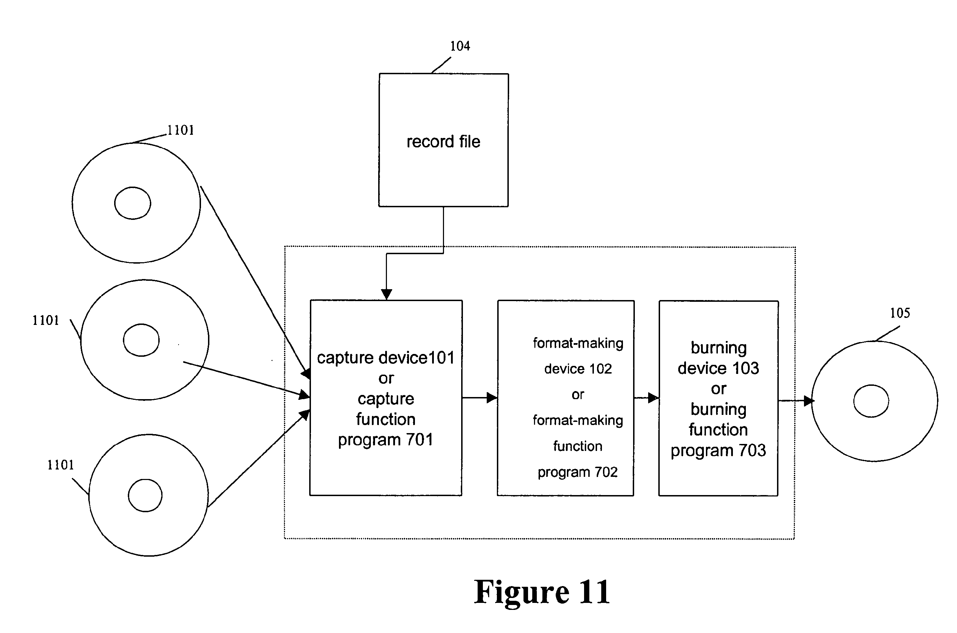

Figure 11 illustrates the operation action of the inventive video editing system; the record file previously sets the capture device 101. The capture device 101 can read the specific sections of the plurality source compact disks to record them to a targeted compact disk 105 directly through the capture device 101, the format-making device 102, the burning device 103 or directly through the capture function program 701, a format-making function program 702 and a burning function program 703.

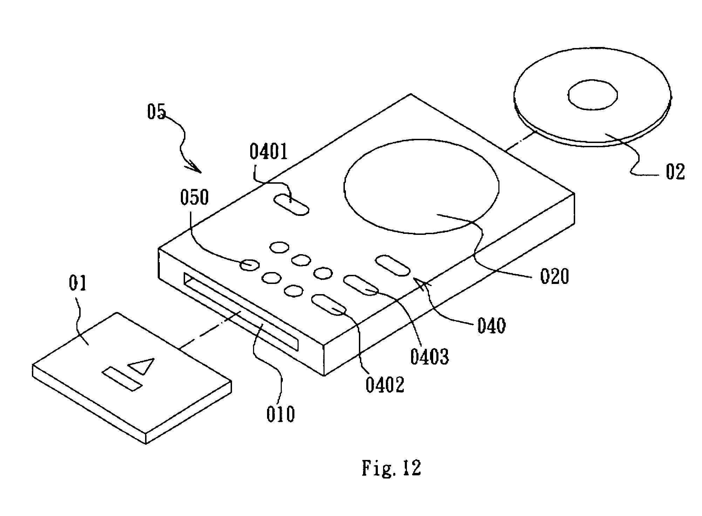

The present invention also provides a portable video editing system. For purpose of video editing, the video editing system is equipped with functional modules capable of transcribing file from one file system to another and of burning video discs by simple operation. Referring to Fig. 12, the portable transcription device 05 according to the present invention is capable of transcribing data contained in a first storage medium for the convenience of being recorded into a second storage medium. In the following embodiment, the first storage medium referred throughout the present invention is directed to a nonvolatile storage medium, which includes but not limited to, a secure digital card (SD card), a multimedia card (MMC), a compact flash Card (CF card) type I, a compact flash Card type II, a microdrive manufactured by IBM corporation, a memory stick, a memory stick duo, a memory stick pro, a smart media card (SM card), an XD card and so forth. The second storage medium referred throughout the present invention is directed to an optical storage medium which is intended to be interpreted in a broadest definition, including recordable compact disc (CD-R), rewritable compact disc (CD-RW), DVD+R disc, DVD-R disc, DVD+RW disc, DVD-RW disc, DVD-RAM disc, DVD-dual layer disc, DVD-multi disc and so forth. However, it is to be realized that the first storage medium and the second storage medium referred herein are not exhaustively restricted to the forms listed above. Instead, the data storage mode and data access manner of the first storage medium and the second storage medium as described above can be exchanged. That is, the first storage medium can be directed to an optical storage device including the recordable/rewritable discs enumerated above, for example, while the second storage medium can be directed to a nonvolatile storage device including the possible memory cards enumerated above. On the other hand, the first storage medium and the second storage medium can be equipped with the same data storage mode and data access manner, but equipped with different data storage format and storage capacity. For example, the first storage medium can be directed to a recordable compact disc (CD-R) while the second storage medium can be directed to a DVD+RW disc. However, it is to be noted that the present invention can satisfy with the conditions mentioned above to transcribe the data contained in a first storage medium as represented within a file system used in the first storage medium into the data as represented within a file system used in a different second storage medium, irrespective of the type of the first storage medium and the second storage medium.

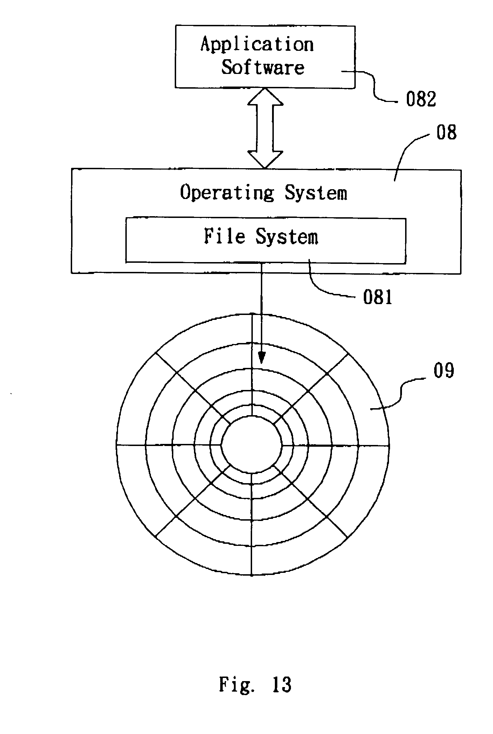

Referring to Fig. 13, as is well known in the art, different file systems 081 may be resident on different types of storage medium due to their compatibility with different operating systems or the prescriptions defined by different storage medium specifications. The file system 081 refereed herein indicates an interface between the operating system 08 and the storage medium 09. For example, when user is desired to request an access to read a file from the storage medium 09, the operating system 08 is capable of opening the required file in response to the request from the storage medium 09. This is because the file system 081 is able to keep track of the information concerning the physical locations of which the required files resides, the directory of which the required file belongs to, the designation of the required file and other related file structure information.

For example, DOS and Windows operating system family pioneered by Microsoft Corporation uses but not limited to FAT file system (including FAT 16 and FAT 32), UNIX operating system pioneered by Novell Corporation uses but not limited to UFS file system, Macintosh operating system pioneered by Apple Computer, Inc. uses but not limited to HFS file system. Because Windows operating system family pioneered by Microsoft Corporation has entered the mainstream of computer operating system, the contemporary memory card generally uses FAT file system as its file system to retain data and related system information.

On the other hand, currently there are provided a number of file storage standards for use by a compact disc, for example, ISO9660, Joliet, Romeo or UDF to serve as its file system. Unfortunately, the file system used in a compact disc is not exactly the same in the respects of file format and file structure with the file system used in a general computer system. In order to allow the user to access the data contained in a compact disc through an operating system, a transcription program capable of transcribing the data as represented within a file system format used by a compact disc into user the data as represented within a file system used by the operating system in each operating system, such that the data contained in a compact disc can be successfully accessed by a user through an operating system in a computer.

Referring to Figs. 1 and 3, in the following embodiment, the present invention provides a portable transcription device 05 operatively independent of the computer system and is capable of transcribing the data contained in a non-volatile storage medium 01 and recording the transcribed data into an optical storage medium 02. The portable transcription device 05 according to the present invention is comprised of a reader module 010, a recording module 020, a control module 030, an input module 040, and a display module 050.

The reader module 010 is used to access the data contained in the non-volatile storage medium 01. In this embodiment, the reader module 010 is implemented by a memory card connector slot. As shown in Fig. 12, this memory card connector slot accommodates a receiving space for the non-volatile storage medium 01 to be received therein.

The recording module 020 is used to record data into the optical storage medium 02 or read the data contained in the optical storage medium 02, and is connected with a control unit 030 which will be described in greater detail hereinafter. In this embodiment, the recording module 020 is directed to a compact disc recordable drive or a compact disc rewritable drive. It is certainly that the optical storage medium 02 has to be matched with the recording module 020. For example, if the recording module 020 is directed to a compact disc recordable drive, the optical storage medium 02 has be to selected as a recordable compact disc, and if the recording module 020 is directed to a compact disc rewritable drive, the optical storage medium 02 has be to selected as a rewritable compact disc.

The control module 030 is respectively connected with the reader module 010 and the recording module 020, and includes a control unit 0301, an inspection unit 0302, and a transcribing unit 0303. The transcribing unit 0303 and the inspection unit 0302 are interconnected with the control unit 0301. The control unit 0301 in this embodiment is directed to a microcontroller, such as an Intel 8086 microprocessor, and serves as the core of the portable transcription device of the present invention. The control unit 0301 is competent to fetch and execute instructions, receive data from the reader module 010, and drive the recording module 020 to record data into the optical storage medium 02.

The inspection unit 0302 is used to check the available free space in the optical storage medium 02. The purpose of the inspection unit 0302 is to perceive the available free space in the optical storage medium 02 by virtue of a read disc information instruction (wherein its OP code is 51h) compiled in ATAPI/SCSI instruction set, and perceive the next writable address (NWA) on the optical storage medium 02 by virtue of a read check/rzone information instruction (wherein its OP code is 52h) also compiled in ATAPI/SCSI instruction set if data is contained on part of the optical storage medium 02 before the optical storage medium 02 is to be undergone a data recording process.

The transcribing unit 0303 is used to transcribe the data contained in the non-volatile memory 01 as represented within the file system in the non-volatile storage medium 01 into the data as represented within the file system in the optical storage medium 02. As stated above, the non-volatile memory 01 takes the FAT file system to allocate files and directories. Consequently, an appropriate transformation for the file system is necessary when it is desired to transcribe the data contained in the non-volatile storage medium 01 so as to be recorded into the optical storage medium 02. In this embodiment, for the purpose of allowing the transcribed data recorded in the optical storage medium 02 to be compatible with various kinds of operating systems, the ISO9660 file system defined by ISO9660 specification which is the most compatible file system with various optical storage media is selected as the file system used in the optical storage medium 02. The transcription process according to the present invention is as follows.

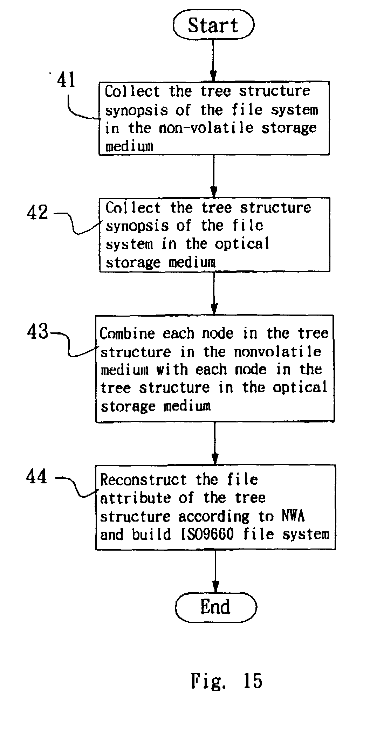

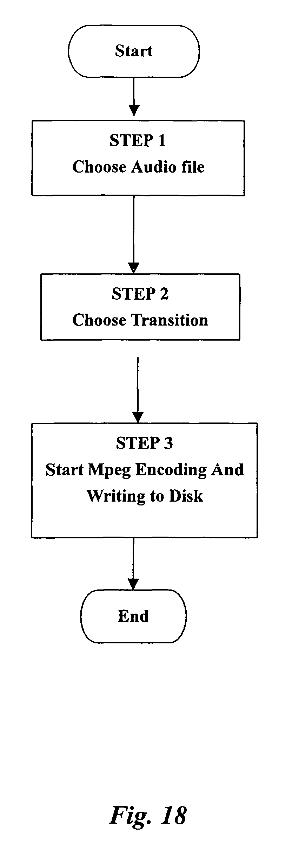

Referring to Fig. 15, the file structure synopsis of the FAT file system in the non-volatile storage medium 01 is collected by the reader module 010, as shown in step 041. That is, the reader module 010 grasps the files for which each cluster holds through the file allocation table (FAT) retained in the non-volatile storage medium 01, and acquire the information on the file tree structure constructed by root directory, file path and file names.

Step 42 is an optional step, which performs the collection of the synopsis of the file tree structure within the file system (such as ISO9660 file system) in the optical storage medium 02. If the optical storage medium 02 contains data before the transcription process starts, the inspection unit 0302 is able to perceive the information related to ISO9660 file system in the optical storage medium 02. If there is no data contained in the optical storage medium 02, there will not exist any information related to the file system in the optical storage medium 02.

Eventually, at shown in steps 43 and 44, each node of the file tree structure in the non-volatile storage medium 01 is combined with each node of the file tree structure in the optical storage medium 02, and the attributes of the file tree structure are reconstructed according to a next writable address (NWA). In this way, an ISO9660 file system is built in the optical storage medium 02.

Besides, in order to avoid errors generated within data during transcription process, the control module 030 further includes a comparison unit 0304. The comparison unit 0304 is able to compare the original data contained in the non-volatile storage medium 01 with the transcribed data contained in the optical storage medium 02 to detect errors resulting from the transcription process.

It is to be explained here that the foregoing inspection unit 0302, the transcribing unit 0303 and the comparison unit 0304 are presented in the form of firmware. That is, the inspection unit 0203, the transcribing unit 303 and the comparison unit 0304 are implemented in such a way by compiling programmable codes, implanting the compiled codes into a non-volatile memory, and then constituting a programmed read-only memory. In this manner, the control unit 0301 can load the inspection unit 0302, the transcribing unit 0302 and the comparison unit 0303 and put them into execution. It is certainly that the control module 030 may further include a random access memory (RAM) 0305 that is accessible from the control unit 0301, and thereby accelerate the progress of the transcription process.

The input module 040 can be directed to an operation panel and coupled with the control unit 0301 for enabling the user to enter inputs to manipulate the portable transcription device according to the present invention. For the convenience of easy control on the portable transcription device, three functional pushbuttons are provided for the input module 040, wherein the first is a Power-On pushbutton 0401, the second is a Recording (REC) pushbutton 0402, and the third is a Recording/Check (REC/Check) 0403.

The display module 050 is connected with the control unit 0301 and is able to display status information related to data reading, recording, and comparison between the transcribed data and the original data, for example, status information indicating the operation power is on, the storage capacity of optical storage medium 02 is full, data recording is in progress and so on. In this embodiment, in order to save cost and power consumption, the display module 050 is implemented by light-emitting diodes (LEDs). Under different conditions, LEDs corresponding to a specific event will be lightened or start blinking with light of different colors to notify the user of associated messages.

Besides, although the portable transcription device according to the present invention can operate independently of a computer, a preferred implementation is to accommodate the portable transcription device 05 of the present invention with a connecting module 060. The connecting module 060 is directed to a USB connector for interconnecting with the portable transcription device 05 with a computer according to the embodiment. The purpose of the connecting module 060 is that if the first storage medium (non-volatile storage medium 01 in the embodiment) uses the same file system with the operating system of a computer connected therewith, data contained in the first storage medium can be directly transferred into the hard disk dive fitted within the computer via the connecting module 060 without the requirement of data transcription. Such a configuration enables the portable transcription device 05 to serve as a card reader without effort.

Referring to Figs. 3 and 5, if the user intends to carry out transcription process, a non-volatile storage medium 01 and an optical storage medium 02 are provided in advance, and the control of the transcription process is accomplished by the input module 040 after the non-volatile storage medium 01 and the optical storage medium 02 are respectively placed into the reader module 010 and recording module 020. For example, as the user depresses the Recording/Check (REC/Check) 0403, the control module 0301 accesses the non-volatile storage medium 01 via the reader module 010 and perceives the data quantity contained in the non-volatile storage medium 01, as shown in step 51.

As shown in step 52, the inspection unit 0302 inspects the optical storage medium 02 by the recording module 020, and determines whether the available free space in the optical storage medium 02 is larger than the data quantity contained in the non-volatile storage medium 01 by reading disc information, files and history record of directories, file allocating table, and next writable address (NWA). It is certainly that the operations associated with step 52 are implemented by loading multiple programmed codes constituting the inspection unit 0302 into the control unit 0301 and executes these codes in turn.

Next at step 53, if the available free space in the optical storage medium 02 is larger than the data quantity contained in the non-volatile storage medium 01, the file format of the non-volatile storage medium 01 is transcribed, i.e. the file as represented within FAT file system is transcribed into the file as represented within ISO 9660 file system. It is certainly that the file contents do not changed, the only changes made in the transcription process are the format of file header and file recording method. Because the transcription process has been fully described in the foregoing, it is not intended to make a detailed discussion in the following.

If the available free space in the optical storage medium 02 is less than the data quantity contained in the non-volatile storage medium 01, the optical storage medium 02 should be renewed and the following steps may continue, as indicated in step 54.

When the transcription process is completed, as indicated in step 55, the control unit 0301 sends the transcribed data to the recording module 020, and then records the transcribed data into the second storage medium 02 by means of the recording module 020. It is to be stressed here that if the an optical storage medium is selected as the second storage medium, the recording module 020 records the transcribed data into the optical storage medium in a manner of multi-session. That is, the transcribed data as represented within ISO9660 file system including primary volume descriptor (PVD), Volume Descriptor Set Terminator (VDST), history record of file and directory, file allocating table and files will be sequentially recorded into the optical storage medium 02 starting from the next writable address. Finally, the close session operation, i.e. lead-out action that indicates that the end of the data has been reached will be performed to complete a session. If this session is not an initial session, the file system description of this session should contain the information related to the file allocations of the last session.

Data can be successively recorded in the new session following the previously recorded session at the next data recording task through the use of multi-session recording technique when there is free space available in the optical storage medium 02. In this manner, the storage space of the optical storage medium 02 can be fully utilized.

Eventually, as indicated in step 56, the control unit 0301 accesses the comparison unit 0304 to compare the data recorded in the optical storage medium 02 and the original data contained in the non-volatile storage medium 01. If no error is detected within the recorded data, the recording process for the transcribed data is accomplished. It should be expounded here that this step is also an optional step. If the user depresses recording pushbutton, steps 51, 52, 53 and 54 will be executed only while eliminating the step of data comparison in order to reduce the total data recording time.

It is to be understood that although the embodiment disclosed hereinbefore takes the method of transcribing data contained in the non-volatile storage medium 01 so as to be recorded into the optical storage medium 02 as an exemplification to illustrate the present invention, actually the reader module 010 (memory card connector slot) and the recording module 020 (compact disc recorder) are both equipped with the functions of data recording and data reading. And by adding the firmware capable of transcribing the data as represented within the file system used in the optical storage medium 02 into the data as represented within the file system used in the non-volatile storage medium 01, the portable transcription device 05 according to the present invention is also capable of transcribing the data contained in the optical storage medium into the data as represented within the file system used in the non-volatile storage medium, and thereby the portable transcription device can act as a two-way data backup utility device.

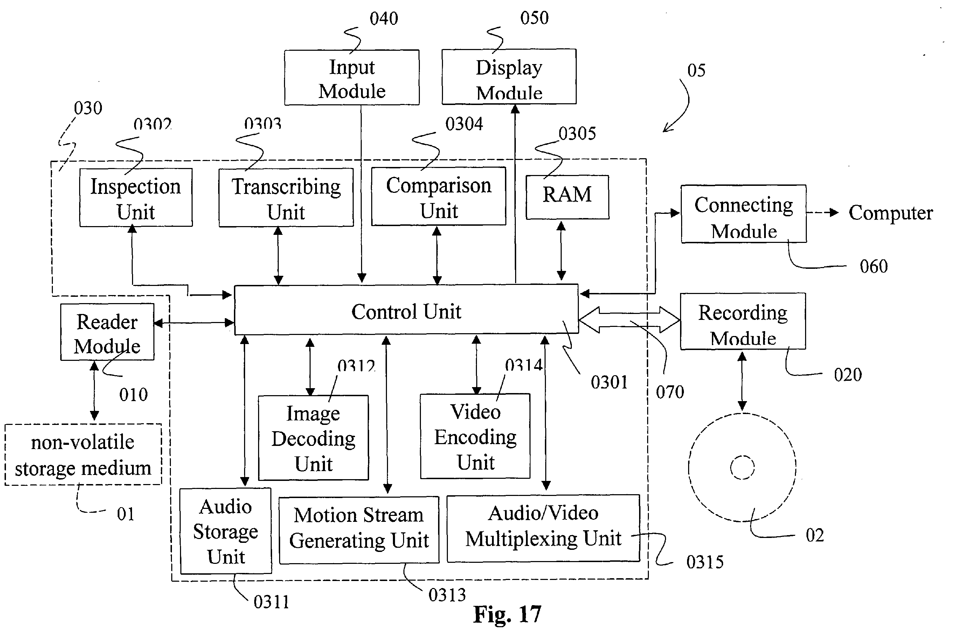

Fig. 17 is a block diagram illustrating the portable transcription device according to one embodiment of the present invention. The embodiment of the present invention allows users to create a video disc 02 using still image files contained in the non-volatile storage medium, such as a Memory Stick, flash memory card, or any other type of memory module. In order to create a video disc ready for playback, the transcription device 05 further comprises a audio storage unit 0312 for storing audio files, and image decoding unit 0312 for decoding encoded images, a motion stream generating unit 0313 for creating video transitions, an video encoding unit 0314 for encoding MPEG files, and an audio/video multiplexing unit 0315 for multiplexing audio and video sources to generate MPEG stream ready for recording, each of which being coupled to the control unit 0301. Still image files can be in the format of JPEG, TIFF, or other image formats. Video formats include MPEG 1 and MPEG 2 for use in a VCD, SVCD, and DVD. For burning a VCD, the video encoding unit 0314 could be a MPEG 1 encoder; and for SVCD and DVD, the video encoding unit 0314 could be a MPEG 2 encoder. In one embodiment, the image decoding unit 0312, the motion stream generating unit 0313, the video encoding unit 0314, and the audio/video multiplexing unit 0315, are programming codes.

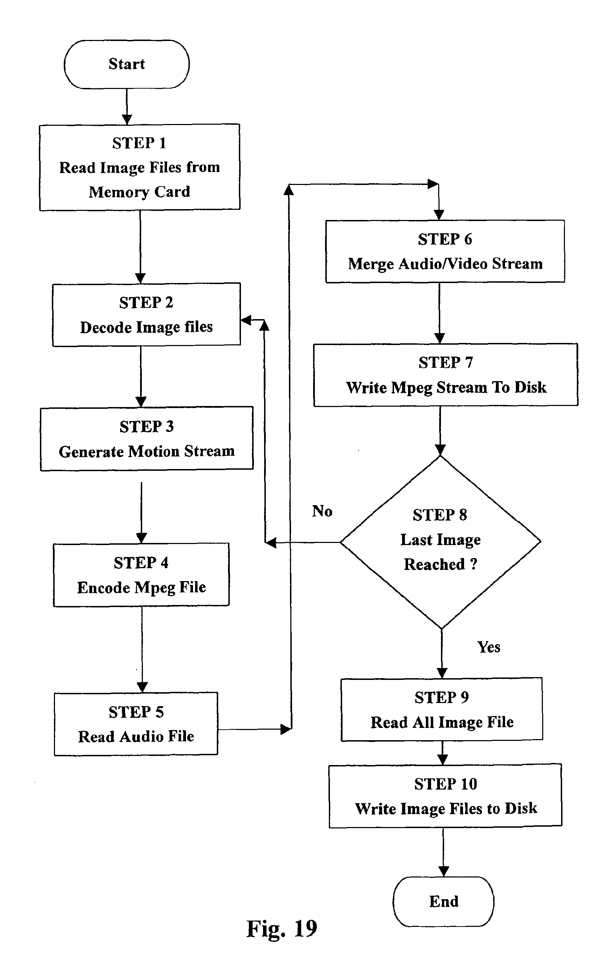

Fig. 18 and Fig. 19 are flowchart diagrams illustrating the procedural steps of using the portable transcription device of Fig. 17 to create video discs. Firstly, in Fig. 18, the user chooses in step 1 one or more audio files stored in the audio storage unit 0311, which can be a ROM, through the operation of the input module 040 and display module 050. The display module 050 can be a small display showing the audio files available using numeric and alphabetic characters, and users manipulate the input module 040 to browse and select one or more of audio files that can be .wav, .aif, or .Mp3 files readable by the audio/video multiplexing unit 0315. Selected audio files are used to add sound tracks to the video disc 02. By selecting more audio files to accompany the animated images, users can produce audio/video effects that are more entertaining. These audio files are preloaded in the audio storage unit 0311. If the audio storage unit 0311 is a ROM, these audio files do not subject to any modification. In one embodiment, the audio storage unit 0311 is itself a non-volatile storage module, such as a MMC card or a SD card, which can be slotted into the reader module 010 and be replaced in the same way as the non-volatile storage medium 01. In another embodiment, the audio files are stored in the non-volatile storage medium 01 along with image files. Such embodiments allow users to use any preferred music files by storing music files in a memory module and plug into the portable prescription device 05. When users deselect all audio files or when audio files are not available, the discs to be created will have only video tracks.

After choosing the audio files to be used in the sound track, in step 2 users choose one or more transitions to be incorporated in the video, again using the input module 040 and display module 050. Because raw data are still image files, to generate motion effects requires that two adjacent images be combined or merged in a digital manner. Typical transitions include fade-in, fade-out, overlap, scale-down and push etc. For example, when a push-from-right transition is chosen to be dropped between a first image and a second image, the second image will appear visually to push the first image out of a display screen from the right of the screen. In the present embodiment, the transition selections include transition time for each transition type, and the time span for each still images.

Finally, when audio files and video transitions are selected and decided, in step 4 users start the actual encoding and writing process of the portable transcription device to burn the video disc 02. In a preferred embodiment, a default combination of audio files and video transitions is set so that users simply depress one single key of the input module 040 to start the encoding and burning process.

Fig.8 illustrates the procedures involved in the encoding of video and audio files and writing to disc. In step 1, the control unit 301 fetches image files contained in the memory card 01 via reader module 010 once an user has inserted the memory card 01 into the transcription device 05 and clicks start. For the reason that at least two images must be ready before applying transition effects, the control unit 0301 will preferably read two images at a time. In step 2, the images read from memory card 1 will be decoded or decompressed by the image decoding unit 0312 into YUV format. In decoding JPEG images, the standard of CCITT T.81 specification and ISO/IEC 10918-1 specification is followed. For TIFF images, TIFF 6.0 specification is adhered to. Note that in this step a scaling of image size is also performed. This is necessary because the size of the still images in the memory card 01 may not conform to that of the video format adopted by conventional TV set or display systems used to display the content of the video disc 02 to be created. In the case of NTSC, the image pixels should be scaled to 352*240 for VCD, and 720*480 pixels for SVCD and DVD.

In step 3, motion stream generating unit 0313 digitally mixes and combine two YUV images to produce motion stream according to the transition types by default or selected by the user. The application of transitions produces a series of frames, each in YUV format. In producing visual transitions, the number of frames per second should be as specified by the video format adopted.

In step 4, these transitional frames, along with two original still images, are encoded into MPEG compliant video stream by video encoding unit 0314. For MPEG 1 encoding, the standard of ISO/IEC 11172-2 specification is followed. For MPEG 2, ISO/IEC 13818-2 specification is adhered to.

In step 5, the control unit 0301 reads audio files by default or selected by the user from the audio storage unit 0311. In step 6 the audio/video multiplexing unit 0315 multiplexes or merges the audio files of the audio storage unit 0311, and the output of the video encoding unit 0314, to create header files and audio/video pack out of which a complete MPEG stream can be generated. In packing, the ISO/IEC 11172-1 specification is followed for VCD, SJ/T 11196-1998 specification for SVCD, and ISO/IEC 13818-1 specification for DVD.

In step 7, the MPEG stream is written to the disc to create a video disc 02. The standards that are incorporated may include Video CD Specification Version 1.1/2.0, Specification for Super VCD system SJ/ T 11196-1998 and DVD Specifications for Read-Only Disk, DVD Specifications for Recordable Disc (DVD-R), DVD Specifications for Rewritable Disc (DVD_RAM), DVD Specifications for Re-recordable Disc (DVD-RW) & DVD Specifications for DVD-RAM/DVD-RW/DVD-R for General Discs. For details, please refer to web page http://www.dvdforum.org/tech-dvdbook.htm.

The control unit 0301 takes full control of the reading, decoding, encoding, and writing-to-disc procedures described above. Initially image files stored in the memory card 01 can be retrieved and temporarily kept in the RAM 0305. But for most of the time the RAM space will not be large enough to hold all image files the memory card 01 supplies. Therefore, for continued encoding and writing to disc, image files should be retrieved from memory card 01 without any time delay. In step 8, a judgment is made by the control unit 0301 to determine whether all image files has been encoded into MPEG video, and whether the last image file has been reached. If not, the rest of the image files will be timely retrieved and taken by the motion stream generating unit 0313, video encoding unit 0314 and audio/video multiplexing unit 0315 for MPEG video encoding. In one embodiment, the control unit 0301 determines the quantity of image files available in the memory card 01 before embarking the above mentioned encoding procedures. In another embodiment, the control unit 0301 monitors the MPEG encoding process and keeps new image files ready for encoding. In any event, the control unit 0301 ensures that all image files are ready for encoding, and terminates the encoding and writing-to-disc procedures once the last image is reached.

While all image files are converted into MPEG video stream and the video disc 02 has been created, the transcription device 05 will initiate backup function in step 9 and step 10 by writing all image files from memory card 01 into the video disc 02. The control unit 0301 may reread all image files from the memory card 01, create a photo directory according to either UDF for DVD or ISO9660 for VCD/SVCD, copy all files into the photo directory, and finally write into disc 02. In backing up images a write-a-session recording is used, which would make the video disc 02 a multi-session disc ready for playback on a typical video disc player, and also ready for computer use, such as file search, file rename, and file edit. In one embodiment, the transcription device 05 is configurable, either by default or user selection, to optionally perform the backup function in burning a video disc.

Referring to Fig. 1 and Fig. 17, the capture device 101 includes the reader module 010; the format-making device includes the transcribing unit 0303; the burning device includes the recording module 020; the operation interface 100 includes the input module 040 and display module 050. Referring to Fig. 7 and Fig. 17, the control unit 0301 performs a function of the main program 700; the reader module performs a function of the capture function program 701; the transcribing unit 0303 performs a function of the format-making function program 702; the recording module 020 performs a function of the burning function program 703. In this case, the non-volatile storage medium 01 may then includes several video discs received by the reader module 010. Under such configuration, the portable device 05 is capable of receiving and selecting video data from a plurality of video sources according to user selection through the input module 040 and display module 50, and then combining these video data and recording into the disc 02 using methods described in Fig. 1 to Fig. 11.

In summary, the portable transcription device of the present invention utilizes the embedded transcribing unit 0303 to transcribe data among different file system, and thus the data contained in the first storage medium can be so transcribed as to be recorded in the second storage medium. This extraordinary characteristic enables the portable transcription device of the present invention to operate independently of any computer system and backup data without effort. The first storage medium can be reused iteratively, which even can act as a two-way data backup utility device. More advantageously, the arrangement of the connecting module 060 enables the portable transcription device of the present invention to connect with a computer system and attain a multi-in-one peripheral device, so that the objects of the present invention can be achieved without doubt.

In addition, the portable transcription device of the present invention allows quick and easy creation of video discs from image files and simultaneous file backup using a simple click, thereby avoiding inconveniences in using a computer. The inventive device is also enabled to edit video data from several sources for backup in a disc.

Although the present invention has been described and illustrated in detail, it is to be clearly understood that the same is by the way of illustration and example only and is not to be taken by way of limitation, the spirit and scope of the present invention being limited only by the terms of the appended claims.
In the following the invention is described in connection with clauses:
1. A portable transcription device comprising:
   a reader module for reading data from a first storage medium;
   a control module coupled to the reader module for transcribing the data as represented by a file system used in the first storage medium into that as represented by a file system used in a second storage medium, wherein the file system used in the first storage medium is different from the file system used in the second storage medium; and
   a recording module controlled by the control module for recording the transcribed data generated by the control module into the second storage medium.
2. The portable transcription device of clause 1 wherein the first storage medium is a non-volatile storage medium and the second storage medium is an optical storage medium.
3. The portable transcription device of clause 2 wherein the non-volatile storage medium is a memory card and the optical storage medium is a compact disc.
4. The portable transcription device of clause 3 wherein the memory card is one of a secure digital card (SD card), a multimedia card (MMC), a compact flash Card type I, a compact flash card type II, a microdrive, a memory stick, a memory stick duo, a memory stick pro, a smart media card (SM card), and an XD card.
5. The portable transcription device of clause 3 wherein the compact disc is one of a recordable compact disc (CD-R), a rewritable compact disc (CD-RW), a DVD+R disc, a DVD-R disc, a DVD+RW disc, a DVD-RW disc, a DVD-RAM disc, a DVD-dual layer disc, and a DVD-multi disc.
6. The portable transcription device of clause 5 wherein the reader module is a memory card reader module and the recording module is one of a compact disc recordable drive and a compact disc rewritable drive.
7. The portable transcription device of clause 1 wherein the control module comprises a microprocessor and a memory being accessible from the microprocessor.
8. The portable transcription device of clause 1 wherein the control module further comprises:
   an inspection module for inspecting an available free space in a second storage medium;
   a transcribing unit for transcribing the data as represented by the file system used in the first storage medium into that as represented by the file system used in the second storage medium.
9. The portable transcription device of clause 1 wherein the first storage medium is an optical storage medium storage medium and the second storage medium is a non-volatile storage medium.
10. The portable transcription device of clause 9 wherein the non-volatile storage medium comprises a memory card and the optical storage medium is a compact disc.
11. The portable transcription device of clause 10 wherein the memory card is one of a secure digital card (SD card), a multimedia card (MMC), a compact flash Card type I, a compact flash card type II, a microdrive, a memory stick, a memory stick duo, a memory stick pro, a smart media card (SM card), and an XD card.
12. The portable transcription device of clause 10 wherein the compact disc is one of a recordable compact disc (CD-R), a rewritable compact disc (CD-RW), a DVD+R disc, a DVD-R disc, a DVD+RW disc, a DVD-RW disc, a DVD-RAM disc, a DVD-dual layer disc, and a DVD-multi disc.
13. The portable transcription device of clause 8 further comprising a connecting module for interconnecting with a computer.
14. The portable transcription device of clause 13 wherein the connecting module is a USB connector.
15. The portable transcription device of clause 1 further comprising an input module for enabling a user to enter an input to control an operation of the portable transcription device.
16. The portable transcription device of clause 1 further comprising a display module for exhibiting status information of the portable transcription device.
17. The portable transcription device of clause 1 further comprising a comparison unit being accessible from the microprocessor for comparing the transcribed data with the data read from the first storage medium by the reader module.
18. A portable transcription device comprising:
   a reader module for reading data from a first optical storage medium;
   a control module coupled to the reader module for transcribing the data as represented by a file system used in the first storage medium into that as represented by a file system used in a second optical medium; and
   a recording module controlled by the control module for recording the transcribed data generated by the control module into the second optical storage medium, wherein a data storage format of the first optical medium is different from that of the second optical storage medium.
19. The portable transcription device of clause 18 wherein the first optical storage medium is one of a recordable compact disc, a rewritable compact disc, a DVD+RW disc, a DVD-RW disc, a DVD-RAM disc, a DVD-dual layer disc, and a DVD-multi disc.
20. The portable transcription device of clause 18 wherein the second optical storage medium is one of a recordable compact disc, a rewritable compact disc, a DVD+RW disc, a DVD-RW disc, a DVD-RAM disc, a DVD-dual layer disc, and a DVD-multi disc.
21. The portable transcription device of clause 18 wherein the control module comprises a microprocessor and a memory being accessible from the microprocessor.
22. The portable transcription device of clause 1 wherein the control module further comprises:
   an inspection module for inspecting an available free space in a second storage medium;
   a transcribing unit for transcribing the data as represented by the file system used in the first optical storage medium into that as represented by the file system used in the second optical storage medium.
23. The portable transcription device of clause 18 further comprising a connecting module for interconnecting with a computer.
24. The portable transcription device of clause 23 wherein the connecting module is a USB connector.
25. The portable transcription device of clause 18 further comprising an input module for enabling a user to enter an input to control an operation of the portable transcription device.
26. The portable transcription device of clause 18 further comprising a display module for exhibiting status information of the portable transcription device.
27. The portable transcription device of clause 18 further comprising a comparison unit being accessible from the microprocessor for comparing the transcribed data with the data read from the first optical storage medium by the reader module.
28. A portable device comprising:
   a reader for reading data contained in a non-volatile storage medium having a first file system;
   an optical recorder for writing data onto an optical storage medium having a second file system other than the first file system;
   a controller coupled with the reader and the recorder for controlling the reading and writing;
   a transcribing unit coupled with the controller for transcribing data between the first file system and the second file system;
   an user interface coupled with the controller for operating the portable device according to user manipulation;
   an image decoder coupled with the controller for decoding images,
   a motion stream generator coupled with the controller for generating a motion stream, wherein the motion stream are generated by applying at least one visual transition among images decoded by the image decoder;
   a video encoder coupled with the controller for encoding the motion stream generated by the motion stream generator into a video stream;
   a audio/video multiplexer coupled with the controller for multiplexing the video stream of the video encoder and an audio source to generate a MPEG stream for writing into an optical storage medium by the optical recorder; and
   a casing enclosing the reader, the optical recorder, the controller, the transcribing unit, the image decoder, the motion stream generator, the video encoder , and the audio/video multiplexer, the casing having a first opening at one end for receiving a non-volatile storage medium in the reader, and a second opening at another end for receiving an optical storage medium in the optical recorder, wherein the user interface is disposed on a surface of the casing;
   wherein the reader, the optical recorder, the controller, the image decoder, the motion stream generator, the video encoder, and the audio/video multiplexer, operate to record a video disc in response to a single action through the user interface.
29. The portable device according to clause 28, further comprising a storage unit coupled with the controller for storing at least one audio file for use by the audio/video multiplexer.
30. The portable device according to clause 29, wherein the storage unit is a non-volatile storage medium received by the reader.
31. The portable device according to clause 29, wherein the controller controls a selection of the at least one audio file used by the audio/video multiplexer according to user selection through the user interface.
32. The portable device according to clause 28, wherein the controller controls a selection of the at least one transition used by the motion stream generator according to user selection through the user interface.
33. The portable device according to clause 28, further comprising a connector coupled with the controller for connecting, and transferring data between, the portable device and a host computer.
34. The portable device of clause 28, further comprising a comparison unit being accessible from the controller for checking data transcribed by the transcribing unit between the first file system and the second file system.
35. A method for recording a video disc ready for playback using the portable device of clause 28, comprising the steps of:
   inserting a non-volatile memory medium containing a
   plurality of image files into the reader;
   inserting an optical storage medium into the optical recorder;
   starting the operations of the reader, the optical recorder, the controller, the transcribing unit, the image decoder, the motion stream generator, the video encoder , and the audio/video multiplexer, to record a video disc by a single action through the user interface.
36. The method of clause 35, further comprising:
   selecting a selection of audio file among the at least one audio file for the audio/video multiplexer through the user interface.
37. The method of clause 35, further comprising:
   selecting a selection of transition among the at least one transition for the motion stream generator through the user interface.
38. The method of clause 35, further comprising:
   enabling the reader, the optical recorder, the controller, and the transcribing unit, so as to record in a session of the video disc a backup of a plurality of image files from the reader.
39. A method for recording a video disc ready for playback using the portable device of clause 30, comprising the steps of:
   inserting a non-volatile storage medium containing a plurality of image files into the reader;
   inserting a non-volatile storage medium containing at least one audio file into the reader;
   inserting an optical storage medium into the optical recorder;
   starting the operations of the reader, the optical recorder, the controller, the transcribing unit, the image decoder, the motion stream generator, the video encoder , and the audio/video multiplexer, to record a video disc by a single action through the user interface.
40. The method of clause 39, further comprising:
   selecting a selection of audio file among the at least one audio file for the audio/video multiplexer through the user interface.
41. The method of clause 39, further comprising:
   selecting a selection of transition among the at least one transition for the motion stream generator through the user interface.
42. The method of clause 39, further comprising:
   enabling the reader, the optical recorder, the controller, the transcribing unit, so as to record in a session of the video disc a backup of a plurality of image files from the reader.
43. A method for recording a video disc, comprising the step of:
   providing a reader for reading a plurality of image files contained in a non-volatile storage medium having a first file system;
   providing an optical recorder for writing data onto an optical storage medium having a second file system other than the first file system;
   providing a controller coupled with the reader and the recorder for controlling the reading and writing;
   providing a transcribing unit coupled with the controller for transcribing data between the first file system and the second file system;
   providing an user interface coupled with the controller for operating the portable device according to user manipulation;
   providing an image decoder coupled with the controller for decoding a plurality of image files,
   providing a motion stream generator coupled with the controller for generating a motion stream, wherein the motion stream are generated by applying at least one visual transition among images decoded by the image decoder;
   providing a video encoder coupled with the controller for encoding the motion stream generated by the motion stream generator into a video stream;
   providing a audio/video multiplexer coupled with the controller for multiplexing the video stream of the video encoder and an audio source to generate a MPEG stream for writing into an optical storage medium by the optical recorder; and
   providing a casing enclosing the reader, the optical recorder, the controller, the transcribing unit, the image decoder, the motion stream generator, the video encoder , and the audio/video multiplexer, the casing having a first opening at one end for receiving a non-volatile storage medium in the reader, and a second opening at another end for receiving an optical storage medium in the optical recorder, wherein the user interface is disposed on a surface of the casing; and
   enabling the reader, the optical recorder, the controller, the transcribing unit, the image decoder, the motion stream generator, the video encoder, and the audio/video multiplexer, so as to record a video disc in response to a single action through the user interface.
44. The method of clause 43, further comprising:
   providing a storage unit coupled to the controller for storing a plurality of audio files; and
   selecting a selection of audio files among the plurality of audio files for the audio/video multiplexer through the user interface.
45. The method of clause 43, further comprising:
   providing a non-volatile storage medium received by the reader for storing a plurality of audio files; and
   selecting a selection of audio files among the plurality of audio files for the audio/video multiplexer through the user interface.
46. The method of clause 43, further comprising:
   selecting a selection of transition among the at least one transition for the motion stream generator through the user interface.
47. The method of clause 43, further comprising:
   enabling the reader, the optical recorder, the controller, the transcribing unit, so as to record in a session of the video disc a backup of a plurality of image files from the reader.
48. A video editing system for dynamically editing a plurality of video information onto a targeted compact disk, comprising:
   a capture device recording an starting location and an ending location of a section in at least one source compact disk to form a first information;
   a format-making device generating a second information for matching a recordable disk format through said first information; and
   a burning device first recording said second information to said targeted compact disk, and then loading the specific section from said source disks according to said first information and correcting the section head and the error-detecting code of said second information to burn in said targeted compact disk.
49. The video editing system of clause 48, wherein said capture device further comprises an operation interface for capturing the section of said video information.
50. The video editing system of clause 48, wherein said first information is a data stream.
51. The video editing system of clause 50, wherein said data stream further comprises a plurality of sections.
52. The video editing system of clause 48, wherein said second information includes a necessary file system and the video compact disk information of said targeted compact disk.
53. A video editing method for dynamically editing a plurality of video information onto a targeted compact disk, comprising:
   recording a starting location and an ending location of a section of at least one source compact disk to form a first information;
   generating a second information for matching a recordable disk format through said first information;
   recording said second information to said targeted compact disk;
   loading the specific section from said source compact disk in sequence and correcting the section head and the error-detecting code of said second information; and
   burning said video information to said targeted compact disk.
54. The video editing method of clause 53, wherein said first information is a data stream.
55. The video editing method of clause 54, wherein said data stream comprises a plurality of sections.
56. The video editing method of clause 53, wherein said second information includes a necessary file system and the video compact disk information of said targeted compact disk.
57. A video editing system for dynamically editing a plurality of video information to a targeted compact disk, comprising:
   a capture device providing an operation interface to record a starting location and an ending location of a specific section in a compact disk to form a first information;
   a format-making device generating a file system and a video compact disk information field for matching a recordable disk format through said first information; and
   a burning device recording said file system and said video compact disk information field to said targeted compact disk, and then loading said specific section from said source compact disk and correcting the section head and the error-detecting code of said second information to burn in said target compact disk.
58. The video editing system of clause 57, wherein said first information is a data stream.
59. The video editing system of clause 58, wherein said data stream comprises a plurality of sections.
60. A video editing method for dynamically editing a plurality of video information to a targeted compact disk, comprising:
   recording starting locations and ending locations of a plurality of sections to form a first information;
   generating a file system and a video compact disk information field for matching a recordable disk format through said first information;
   recording said file system and said video compact disk information field to said targeted compact disk;
   loading said video information in sequence and correcting the section head and the error-detecting code thereof; and
   burning said video information to said targeted compact disk in sequence.
61. The video editing method of clause 60, wherein said first information is a data stream.
62. The video editing method of clause 61, wherein said data stream comprises a plurality of sections.
63. A video editing software system for dynamically editing a plurality of video information to a targeted compact disk, comprising:
   a main program generating an operation window for capturing sections of said video information;
   a capture program recording the starting location and the ending location of said sections to form a plurality of first information;
   a format-making program generating a second information for matching the recordable compact disk format through said first information; and
   a burning program recording said second information data to said targeted compact disk at first, and then loading the first information and correcting the section head and the error-detecting code of said second information to burn in said targeted compact disk,
   wherein said main program calling said capture program through said operation interface, said capture program generating said first information to call said format-making program, said format-making program generating said second information to call said burning program to produce said targeted compact disk.
64. The video editing software system of clause 63, wherein said first information is a data stream.
65. The video editing software system of clause 64, wherein said data stream comprises a plurality of sections.
66. The video editing software system of clause 63, wherein said second information includes a necessary file system and video compact disk information of said targeted compact disk.
67. A video editing system for recording a batch of plurality video information onto a targeted disk, comprising:
   a capture device recording a starting location and an ending location of at least one source disk to form information for matching a recordable disk format; and
   a burning device recording said information to a preserved location of said targeted compact disk, and then loading specific sections from said source disks depending on said information and correcting the section head and the error-detecting code thereof to burn in the other locations on said targeted disk.
68. The video editing system of clause 67, wherein said capture device further comprises an operation interface for capturing the sections of said video information.
69. The video editing system of clause 67, wherein said information matches the recordable format of the multi-section.
70. The video editing system of clause 67, wherein said information matches the recordable format of the reserved track.
71. The video editing system of clause 67, wherein said preserved location is the starting track of said targeted disk for recording each video information location of said target disk.
72. A video editing software method for recording a batch of plurality video information to a targeted disk, comprising:
   recording a starting location and an ending location of at least one source disk to form information for matching a recordable disk format;
   recording said information to the preserved location of said targeted disk;
   loading specific sections from said source disks in sequence and correcting the section head and the error-detecting code thereof; and
   burning said specific video information to said targeted disk.
73. The method of clause 72, wherein said capture device further comprises an operation interface for capturing the sections of said video information.
74. The method of clause 72, wherein said information matches the recordable format of the multi-section.
75. The method of clause 72, wherein said information matches the recordable format of the reserved track.
76. The method of clause 72, wherein said preserved location is the starting track of said targeted disk for recording each said video information location of said targeted disk.

## Claims

1. A method for recording a disc, comprising the step of:
providing a reader for reading data contained in a non-volatile storage medium;
providing an optical recorder for writing data onto an optical storage medium;
providing a controller coupled with the reader and the recorder for controlling the reading and writing;
providing a casing enclosing the reader, the optical recorder, and the controller, the casing having a first opening at one end for receiving a non-volatile storage medium in the reader, and a second opening at another end for receiving an optical storage medium in the optical recorder, wherein an user interface coupling with the controller is disposed on a surface of the casing.

2. The method of claim 1, further comprising the step of:
providing a transcribing unit coupled with the controller for transcribing data between a first file system and a second file system.

3. The method of claim 1 or 2, further comprising the step of:
providing an image decoder coupled with the controller for decoding image files,
providing a motion stream generator coupled with the controller for generating a motion stream, wherein the motion stream are generated by applying at least one visual transition among images decoded by the image decoder;
providing a video encoder coupled with the controller for encoding the motion stream generated by the motion stream generator into a video stream;
providing a audio/video multiplexer coupled with the controller for multiplexing the video stream of the video encoder and an audio source to generate a MPEG stream for writing into an optical storage medium by the optical recorder.

4. The method of one of claims 1 to 3, further comprising:
enabling the reader, the optical recorder, the controller, the transcribing unit, the image decoder, the motion stream generator, the video encoder, and the audio/video multiplexer, so as to record a video disc out of the image files in response to a single action through the user interface.

5. The method of one of claims 1 to 4, further comprising:
enabling the reader, the optical recorder, the controller, the transcribing unit, so as to record in a session of the video disc a backup of the image files.

6. The method of one of claims 1 to 5, further comprising:
providing a storage unit coupled to the controller for storing a plurality of audio files; and
selecting a selection of audio files among the plurality of audio files for the audio/video multiplexer through the user interface.

7. The method of on of claims 1 to 6, further comprising:
providing a non-volatile storage medium received by the reader for storing a plurality of audio files; and
selecting a selection of audio files among the plurality of audio files for the audio/video multiplexer through the user interface.

8. The method of one of claims 1 to 7, further comprising:
selecting a selection of transition among the at least one transition for the motion stream generator through the user interface.

9. The method of one of claims 1 to 8, further comprising:
recording starting locations and ending locations of a plurality of sections from the reader to form a first information;
generating a file system and a video compact disk information field for matching a recordable disk format through the first information;
recording the file system and the video compact disk information field to a targeted compact disk;
loading the video information in sequence and correcting the section head and the error-detecting code thereof; and
burning the video information to the targeted compact disk in sequence.

10. The method of one of claims 1 to 9, further comprising:
providing a plurality of source discs received by the reader for providing the plurality of sections
